# EUROPEAN PATENT APPLICATION

(11) **EP 4 790 748 A1**
(43) Date of publication of application: **12.08.2026**
(21) Application number: 23960261.8
(22) Date of filing: 28.11.2023
(51) Int. Cl.: H01L 23/00, H10H 20/00, H01L 25/075

(54) **TRANSFER METHOD OF SEMICONDUCTOR LIGHT-EMITTING DEVICE FOR DISPLAY PIXELS**

(71) Applicant: LG Electronics Inc., Yeongdeungpo-gu Seoul 07336 (KR)
(72) Inventor: KANG, Byungjun, Seoul 06772 (KR); HWANG, Sunghyun, Seoul 06772 (KR); OH, Donghae, Seoul 06772 (KR); PARK, Hyungjo, Seoul 06772 (KR)
(74) Representative: Schott, Jakob Valentin
(86) International application number: PCT/KR2023/019377
(87) International publication number: WO 2025/116062

(57) **Abstract**

A transfer method of a semiconductor light-emitting device for a display pixel includes a semiconductor light-emitting device including a light-emitting structure including a first conductivity type semiconductor layer, an active layer disposed on the first conductivity type semiconductor layer, and a second conductivity type semiconductor layer disposed on the active layer, and including a passivation layer disposed on the light-emitting structure, wherein the method includes forming a sacrificial layer on the semiconductor light-emitting device and bonding the semiconductor light-emitting device to a transfer substrate with the sacrificial layer interposed therebetween, and the sacrificial layer may be disposed between the semiconductor light-emitting device and the transfer substrate.

## Description

### Technical Field

An embodiment relates to a transfer method of a semiconductor light-emitting device for a display pixel.

### Background Art

Large-area displays include a liquid crystal display (LCD), an OLED display, and a micro-LED display.

The micro-LED display is a display using, as a display element, a micro-LED which is a semiconductor light-emitting device having a diameter or cross-sectional area of 100µm or less.

Since the micro-LED display uses the micro-LED, which is a semiconductor light-emitting device, as a display element, it has excellent performance in many characteristics such as contrast ratio, response speed, color reproduction rate, viewing angle, brightness, resolution, lifetime, luminous efficiency, or luminance.

In particular, the micro-LED display has an advantage in that a screen can be separated and combined in a modular manner, so that size or resolution can be freely adjusted, and has an advantage that a flexible display can be implemented.

However, since a large micro-LED display requires several millions or more of micro-LEDs, there is a technical problem in that it is difficult to rapidly and accurately transfer the micro-LEDs onto a display panel.

Recently developed transfer technologies include a pick and place process, a Laser Lift-off method, or a self-assembly method.

Among these, the self-assembly method is a method in which a semiconductor light-emitting device finds an assembly position by itself in a fluid, and is advantageous for implementation of a large-area display device.

Recently, in US Patent No. 9,825,202, a micro-LED structure suitable for self-assembly has been proposed, however, research on a technology for manufacturing a display through self-assembly of the micro-LED is still insufficient.

In particular, in the prior art, when several millions or more of semiconductor light-emitting devices are rapidly transferred to a large display, a transfer speed can be improved, but a transfer error rate may increase, and thus there is a technical problem that a transfer yield is lowered.

Meanwhile, in the related art, a transfer process of a self-assembly method using dielectrophoresis (DEP) has been attempted, however, there is a problem that a self-assembly rate is low due to non-uniformity of a DEP force and the like.

In addition, an organic material is used in a transfer process of the semiconductor light-emitting device, and there is a problem that the organic material remains in a subsequent process and acts as a foreign substance, thereby causing contamination of the semiconductor light-emitting device.

### Mode for Invention

### Technical Problem

One of technical problems of the embodiment is to simplify a transfer process of a semiconductor light-emitting device.

In addition, one of technical problems of the embodiment is to prevent generation of foreign substances in a transfer process.

In addition, one of technical problems of the embodiment is to prevent bonding defects between a semiconductor light-emitting device and a transfer substrate.

In addition, one of technical problems of the embodiment is to prevent misalignment of a miniaturized chip during a transfer process.

In addition, one of technical problems of the embodiment is to improve a transfer rate of a semiconductor light-emitting device.

The technical problems of the embodiment are not limited to those described in this section, and include those that can be understood through the description of the invention.

### Technical Solution

A transfer method of a semiconductor light-emitting device for a display pixel according to an embodiment, in a transfer method of a semiconductor light-emitting device including a light-emitting structure including a first conductivity type semiconductor layer, an active layer disposed on the first conductivity type semiconductor layer, and a second conductivity type semiconductor layer disposed on the active layer, and including a passivation layer disposed on the light-emitting structure, the transfer method comprising: forming a sacrificial layer on the semiconductor light-emitting device; and bonding the semiconductor light-emitting device to a transfer substrate with the sacrificial layer interposed therebetween; wherein the sacrificial layer may be disposed between the semiconductor light-emitting device and the transfer substrate.

In addition, in an embodiment, an organic material may not be disposed between the semiconductor light-emitting device and the transfer substrate.

In addition, in an embodiment, the sacrificial layer 145 may include at least of Al, Cu, Ag, Au, Ni, Pt, W, Ti, Mo, Fe, Co, Sn, Zn, Pb, Mg, carbon steel, Inconel, or stainless steel.

In addition, in an embodiment, the transfer substrate may further include a first metal layer.

In addition, in an embodiment, the first metal layer may include the same metal as the sacrificial layer.

In addition, the embodiment may further include forming a second electrode on a rear surface of the first conductivity type semiconductor layer.

In addition, the embodiment may further include forming a side electrode on a rear surface of the second electrode.

In addition, in an embodiment, the transfer substrate may include a bonding region which is a region to which the semiconductor light-emitting device is bonded, and may include a second-first electrode disposed outside the bonding region of the transfer substrate.

In addition, the embodiment may further include removing the sacrificial layer to separate the semiconductor light-emitting device from the transfer substrate, and in the bonding region of the transfer substrate, a surface of the transfer substrate may be exposed.

In addition, in an embodiment, the bonding the semiconductor light-emitting device to the transfer substrate may be performed within 100 to 1000, and a pressure may be performed within a range of 500 N to 100 kN.

### Advantageous Effects

A transfer method of a semiconductor light-emitting device for a display pixel according to an embodiment has a technical effect that a transfer process of a semiconductor light-emitting device can be simplified.

For example, the embodiment can simplify the transfer process by performing a bonding process without organic material patterning.

In addition, the embodiment has a technical effect that contamination of the semiconductor light-emitting device can be prevented in the transfer process.

For example, the embodiment can prevent contamination of the semiconductor light-emitting device because the bonding process is performed without forming an organic material that acts as a foreign substance in a fluid.

In addition, the embodiment has a technical effect that misalignment of a miniaturized chip can be prevented.

For example, the embodiment can prevent a problem in which a chip is misaligned due to fluidity of an organic material during bonding.

In addition, the embodiment has a technical effect that a transfer rate of the semiconductor light-emitting device can be improved.

For example, the embodiment can prevent a foreign substance from penetrating into an assembly hole and interfering with transfer of the semiconductor light-emitting device.

The technical effects of the embodiment are not limited to those described in this section, and include those that can be understood through the description of the invention.

### Description of Drawings

FIG. 1 is an exemplary view of a living room of a house in which a display device according to an embodiment is disposed.
FIG. 2 is an enlarged view of a first panel region in the display device of FIG. 1.
FIG. 3 is a cross-sectional view taken along line B1-B2 of region A2 of FIG. 2.
FIG. 4 is an exemplary view in which a light-emitting device is assembled on a substrate by a self-assembly method according to an embodiment.
FIG. 5 is an SEM image showing a bonding state of a semiconductor light-emitting device internally developed technology.
FIGS. 6 to 11 are process views of a transfer method of a semiconductor light-emitting device according to a first embodiment.
FIG. 12 is a view showing a transfer substrate to which an embodiment is applied.

### Mode for Invention

Hereinafter, embodiments disclosed in the present specification will be described in detail with reference to the accompanying drawings. In the following description, suffixes 'module' and 'unit' for components used in the description are given or used interchangeably in consideration of ease of preparing the specification, and do not have meanings or roles distinguished from each other. In addition, the accompanying drawings are provided to easily understand the embodiments disclosed in the present specification, and the technical idea disclosed in the present specification is not limited by the accompanying drawings. In addition, when an element such as a layer, a region, or a substrate is referred to as being on another element, it includes both a case in which the element is directly on another element and a case in which another intermediate element is present therebetween.

The display device described in the present specification may include a digital TV, a mobile phone, a smart phone, a laptop computer, a terminal for digital broadcasting, a PDA, a PMP, a navigation device, a slate PC, a tablet PC, an ultra-book, a desktop computer, and the like. However, a configuration according to an embodiment described in the present specification can be applied to a device capable of displaying even in a new product form to be developed later.

Hereinafter, a light-emitting device according to an embodiment and a display device including the same will be described.

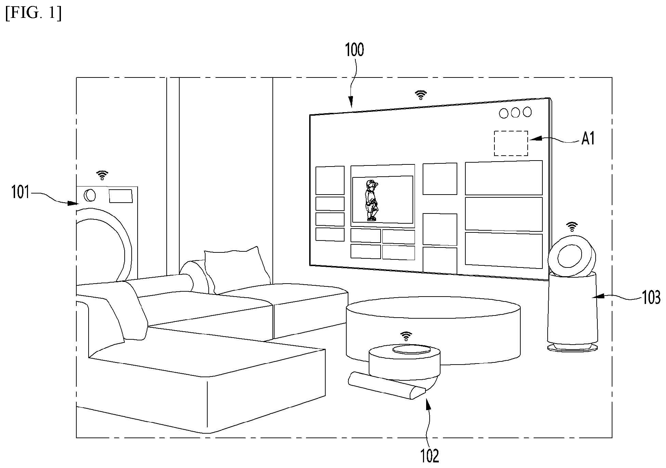

FIG. 1 illustrates a living room of a house in which a display device 100 according to an embodiment is disposed.

The display device 100 according to an embodiment can display states of various electronic products such as a washing machine 101, a robot cleaner 102, and an air purifier 103, can communicate with each electronic product based on IoT, and can control each electronic product based on setting data of a user.

The display device 100 according to an embodiment may include a flexible display fabricated on a thin and flexible substrate. The flexible display can be bent or rolled like paper while maintaining characteristics of a conventional flat display.

In the flexible display, visual information can be implemented by independently controlling light emission of unit pixels arranged in a matrix form. The unit pixel means a minimum unit for implementing one color. The unit pixel of the flexible display can be implemented by a light-emitting device. In the embodiment, the light-emitting device may be a micro LED or a nano LED, but is not limited thereto.

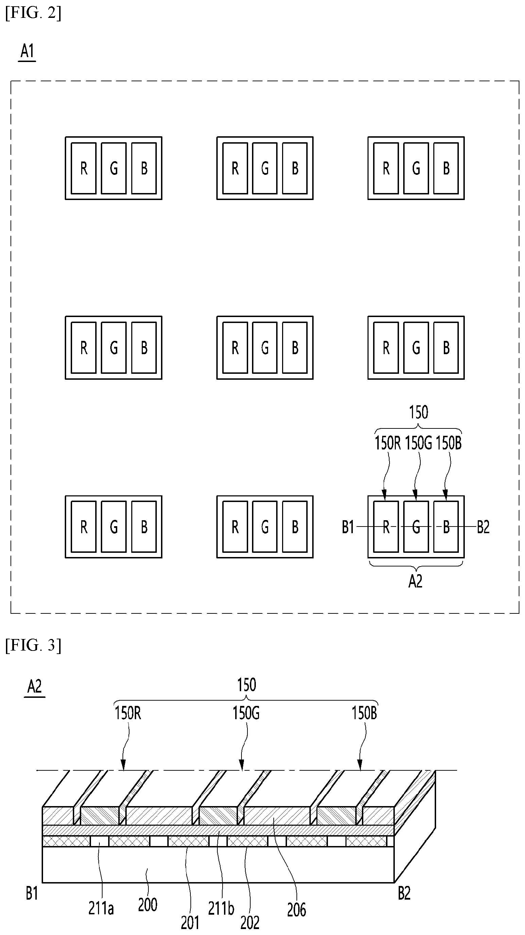

FIG. 2 is an enlarged view of a first panel region A1 in the display device of FIG. 1.

Referring to FIG. 2, the display device 100 according to the embodiment may be manufactured such that a plurality of panel regions such as the first panel region A1 are mechanically and electrically connected by tiling.

The first panel region A1 may include a plurality of light-emitting devices 150 disposed for each unit pixel PX of FIG. 2.

For example, the unit pixel PX may include a first sub-pixel PX1, a second sub-pixel PX2, and a third sub-pixel PX3. For example, a plurality of red light-emitting devices 150R may be disposed in the first sub-pixel PX1, a plurality of green light-emitting devices 150G may be disposed in the second sub-pixel PX2, and a plurality of blue light-emitting devices 150B may be disposed in the third sub-pixel PX3. The unit pixel PX may further include a fourth sub-pixel in which a light-emitting device is not disposed, but is not limited thereto. Meanwhile, the light-emitting device 150 may be a semiconductor light-emitting device.

Next, FIG. 3 is a cross-sectional view taken along line B1-B2 of region A2 of FIG. 2.

Referring to FIG. 3, the display device 100 according to the embodiment may include a substrate 200, assembly wirings 201 and 202, a first insulating layer 211a, a second insulating layer 211b, a third insulating layer 206, and a plurality of light-emitting devices 150.

The assembly wirings may include a first assembly wiring 201 and a second assembly wiring 202 spaced apart from each other. The first assembly wiring 201 and the second assembly wiring 202 may be provided to generate a dielectrophoretic force for assembling the light-emitting device 150. In addition, the first assembly wiring 201 and the second assembly wiring 202 may be electrically connected to electrodes of the light-emitting device and may function as electrodes of a display panel.

The assembly wirings 201 and 202 may be formed of a transparent electrode ITO or may include a metal material having excellent electrical conductivity. For example, the assembly wirings 201 and 202 may be formed of at least one of Ti, Cr, Ni, Al, Pt, Au, and W, or may be formed of an alloy thereof.

The first insulating layer 211a may be disposed between the first assembly wiring 201 and the second assembly wiring 202, and the second insulating layer 211b may be disposed on the first assembly wiring 201 and the second assembly wiring 202. The first insulating layer 211a and the second insulating layer 211b may be an oxide layer or a nitride layer, but are not limited thereto.

The light-emitting device 150 may include a red light-emitting device 150R, a green light-emitting device 150G, and a blue light-emitting device 150B to form each unit sub-pixel, but is not limited thereto, and may implement red and green colors by including a red phosphor and a green phosphor.

The substrate 200 may be formed of glass or polyimide. In addition, the substrate 200 may include a flexible material such as PEN (Polyethylene Naphthalate) or PET (Polyethylene Terephthalate). In addition, the substrate 200 may be a transparent material, but is not limited thereto.

The third insulating layer 206 may include a material having insulation and flexibility such as polyimide, PEN, or PET, and may be integrally formed with the substrate 200 to form a single substrate.

The third insulating layer 206 may be a conductive adhesive layer having adhesiveness and conductivity, and the conductive adhesive layer may have flexibility to enable a flexible function of the display device. For example, the third insulating layer 206 may be an anisotropic conductive film (ACF), an anisotropic conductive medium, or a conductive adhesive layer such as a solution including conductive particles. The conductive adhesive layer may be electrically conductive in a vertical direction with respect to thickness, but electrically insulating in a horizontal direction with respect to thickness.

The third insulating layer 206 may include an assembly hole 203 into which the light-emitting device 150 is inserted. Accordingly, during self-assembly, the light-emitting device 150 may be easily inserted into the assembly hole 203 of the third insulating layer 206. The assembly hole 203 may be referred to as an insertion hole, a fixing hole, or an alignment hole.

A spacing between the assembly wirings 201 and 202 may be formed to be smaller than a width of the light-emitting device 150 and a width of the assembly hole 203, so that an assembly position of the light-emitting device 150 using an electric field can be more precisely fixed.

The third insulating layer 206 may be formed on the assembly wirings 201 and 202 to protect the assembly wirings 201 and 202 from a fluid 1200 and to prevent leakage of current flowing in the assembly wirings 201 and 202. The third insulating layer 206 may be formed of an inorganic insulating material such as silica or alumina or an organic insulating material in a single layer or multiple layers.

In addition, the third insulating layer 206 may include a material having insulation and flexibility such as polyimide, PEN, or PET, and may be integrally formed with the substrate 200 to form a single substrate.

The third insulating layer 206 may be an insulating layer having adhesiveness or may be a conductive adhesive layer having conductivity. The third insulating layer 206 may have flexibility to enable a flexible function of the display device.

The third insulating layer 206 may have a partition wall, and the assembly hole 203 may be formed by the partition wall. For example, when the substrate 200 is formed, a portion of the third insulating layer 206 is removed so that each of the light-emitting devices 150 may be assembled in the assembly hole 203 of the third insulating layer 206.

The substrate 200 may include the assembly hole 203 in which the light-emitting devices 150 are coupled, and a surface on which the assembly hole 203 is formed may be in contact with a fluid 1200. The assembly hole 203 may guide an accurate assembly position of the light-emitting device 150.

Meanwhile, the assembly hole 203 may have a shape and a size corresponding to a shape of the light-emitting device 150 to be assembled at a corresponding position. Accordingly, it is possible to prevent another light-emitting device from being assembled in the assembly hole 203 or a plurality of light-emitting devices from being assembled.

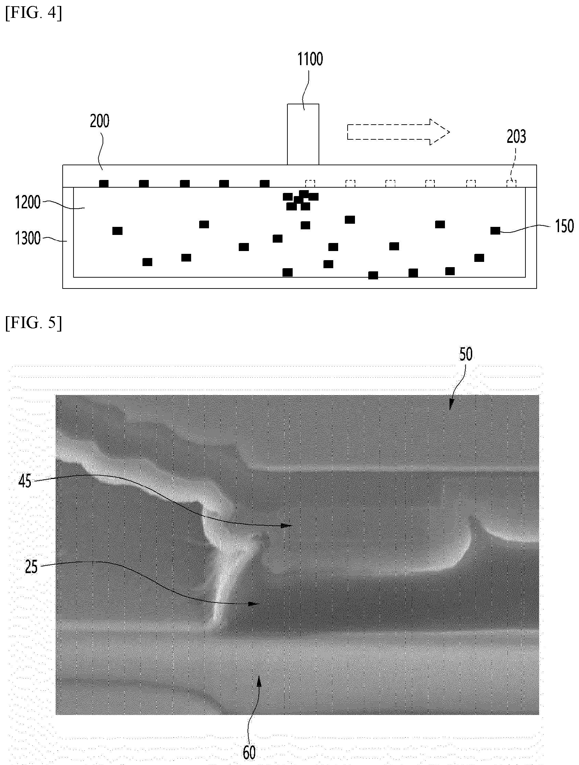

FIG. 4 is a view illustrating an example in which a light-emitting device is assembled on a substrate by a self-assembly method according to an embodiment, and a self-assembly method of the light-emitting device will be described with reference to the drawings.

The substrate 200 may be a panel substrate of a display device. In the following description, the substrate 200 will be described as a panel substrate of a display device, but the embodiment is not limited thereto.

Referring to FIG. 4, a plurality of light-emitting devices 150 may be introduced into a chamber 1300 filled with a fluid 1200. The fluid 1200 may be water such as ultrapure water, but is not limited thereto. The chamber may be referred to as a water tank, a container, or a vessel.

Thereafter, the substrate 200 may be disposed on the chamber 1300. According to an embodiment, the substrate 200 may be introduced into the chamber 1300.

As shown in FIG. 3, a pair of assembly wirings 201 and 202 corresponding to each of the light-emitting devices 150 to be assembled may be disposed on the substrate 200.

Referring to FIG. 4, after the substrate 200 is disposed, an assembly device 1100 including a magnetic material may move along the substrate 200. As the magnetic material, for example, a magnet or an electromagnet may be used. The assembly device 1100 may move in a state of being in contact with the substrate 200 in order to maximize a region in which a magnetic field acts into the fluid 1200. According to an embodiment, the assembly device 1100 may include a plurality of magnetic materials or may include a magnetic material having a size corresponding to the substrate 200. In this case, a movement distance of the assembly device 1100 may be limited within a predetermined range.

By a magnetic field generated by the assembly device 1100, the light-emitting device 150 in the chamber 1300 may move toward the assembly device 1100.

The light-emitting device 150 may enter the assembly hole 203 by a dielectrophoretic force (DEP force) while moving toward the assembly device 1100 and may be brought into contact with the substrate 200.

Specifically, the assembly wirings 201 and 202 form an electric field by power supplied from the outside, and a dielectrophoretic force may be formed between the assembly wirings 201 and 202 by the electric field. By the dielectrophoretic force, the light-emitting device 150 may be fixed in the assembly hole 203 on the substrate 200.

By an electric field applied by the assembly wirings 201 and 202 formed on the substrate 200, the light-emitting device 150 in contact with the substrate 200 may be prevented from being separated due to movement of the assembly device 1100. According to the embodiment, by the self-assembly method using the above-described electromagnetic field, a time required for assembling each of the light-emitting devices 150 on the substrate 200 can be rapidly reduced, so that a large-area high-resolution display can be implemented more rapidly and economically.

At this time, a predetermined solder layer (not shown) may be formed between the light-emitting device 150 assembled on the assembly hole 203 of the substrate 200 and an assembly electrode to improve bonding strength of the light-emitting device 150.

Next, a molding layer (not shown) may be formed in the assembly hole 203 of the substrate 200. The molding layer may be a transparent resin or may be a resin including a reflective material or a scattering material.

FIG. 5 is a photograph showing a part of a transfer process of a semiconductor light-emitting device internally developed technology. In the transfer process of the semiconductor light-emitting device internally developed technology, a sacrificial layer and a bonding material are used when fixing the semiconductor light-emitting device to a temporary substrate. Referring to FIG. 5, a sacrificial layer 45 exists on the semiconductor light-emitting device 50, and a bonding material 25 is disposed for bonding with a transfer substrate 60, so that the semiconductor light-emitting device 50 may be bonded on the transfer substrate 60. The sacrificial layer may include a metal material. In addition, the bonding material may include an organic material.

Meanwhile, in a process of separating the semiconductor light-emitting device 50 from the transfer substrate 60, the bonding material 25 remains. The bonding material 25 may remain on a surface of a temporary substrate and may exist in a region where the semiconductor light-emitting device is bonded. In addition, the bonding material 25 may remain on the semiconductor light-emitting device 50 and may act as a foreign substance in a fluid during fluid dispersion. Accordingly, the remaining bonding material acts as a foreign substance in a subsequent process and becomes a cause of lowering a yield of the transfer process by penetrating into an assembly hole or adhering to a surface of the semiconductor light-emitting device.

In addition, as the semiconductor light-emitting device is miniaturized, the bonding material 25 is also miniaturized, so that difficulty of patterning increases, bonding strength decreases, and the organic material may cause misalignment of a chip.

Hereinafter, an embodiment for solving the above problem will be described.

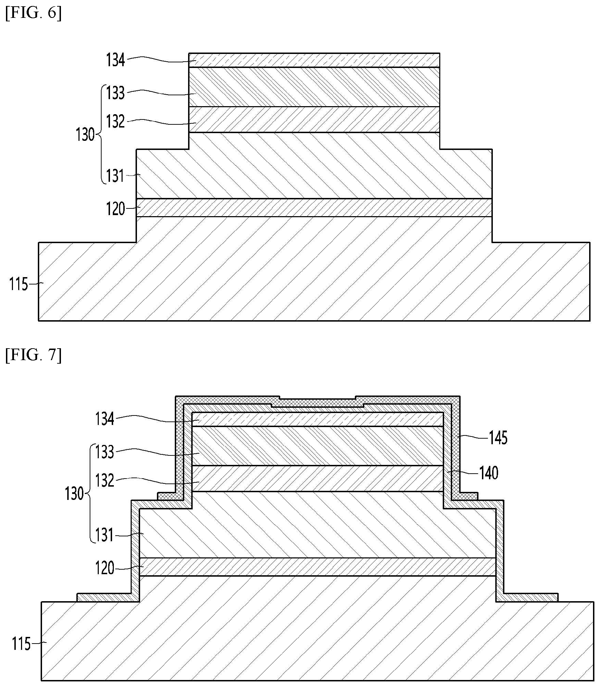

FIGS. 6 to 11 are process views showing a transfer method of a semiconductor light-emitting device for a display pixel according to an embodiment. Referring to FIG. 6, a buffer layer 120 may be formed on a growth substrate 115. In addition, a light-emitting structure 130 may be formed on the buffer layer 120. The light-emitting structure 130 may include a first conductivity type semiconductor layer 131, an active layer 132 disposed on the first conductivity type semiconductor layer 131, and a second conductivity type semiconductor layer 133 disposed on the active layer 132.

The first conductivity type semiconductor layer 131 may be an n-type semiconductor layer, and the second conductivity type semiconductor layer 133 may be a p-type semiconductor layer, but is not limited thereto. The first conductivity type semiconductor layer 131, the active layer 132, and the second conductivity type semiconductor layer 133 may be formed of a compound semiconductor material. For example, the compound semiconductor material may be a group III-V compound semiconductor material or a group II-VI compound semiconductor material. For example, the compound semiconductor may be selected from the group consisting of binary compounds including GaP, GaAs, GaSb, AlP, AlAs, AlSb, InP, InAs, and InSb, and mixtures thereof; ternary compounds selected from the group consisting of GaNP, GaNAs, GaNSb, GaPAs, GaPSb, AlInP, AlNP, AlNAs, AlNSb, AlPAs, AlPSb, InNP, InNAs, InNSb, InPAs, InPSb, GaAlNP, and mixtures thereof; and quaternary compounds selected from the group consisting of AlGaInP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof.

For example, the first conductivity type semiconductor layer 131 may include a first conductive dopant, and the second conductivity type semiconductor layer 133 may include a second conductive dopant. For example, the first conductive dopant may be an n-type dopant such as silicon Si, and the second conductive dopant may be a p-type dopant such as boron B.

The active layer 132 is a region generating light and may generate light having a specific wavelength band according to material characteristics of the compound semiconductor. In addition, the active layer 132 may have a multiple quantum well structure or a single quantum well structure, and a wavelength band may be determined by an energy bandgap of the compound semiconductor included in the active layer 132. Accordingly, the semiconductor light-emitting device of the embodiment may generate UV light, blue light, green light, or red light according to the energy bandgap of the compound semiconductor included in the active layer 132.

A first electrode 134 may be disposed on the light-emitting structure 130. The first electrode 134 may be formed as a transparent electrode. For example, it may include ITO, IZO, or ZnO, but is not limited thereto.

Referring to FIG. 7, a first passivation layer 140 may be disposed to cover the light-emitting structure 130. The first passivation layer 140 may be formed from an upper surface of the light-emitting structure 130 to a portion of the growth substrate 115. In addition, a sacrificial layer 145 may be formed on the first passivation layer 140. The sacrificial layer 145 may include a metal. For example, the sacrificial layer 145 may include Al, Cu, Ag, Au, Ni, Pt, W, Ti, Mo, Fe, Co, Sn, Zn, Pb, Mg, carbon steel, Inconel, stainless steel, or a combination thereof.

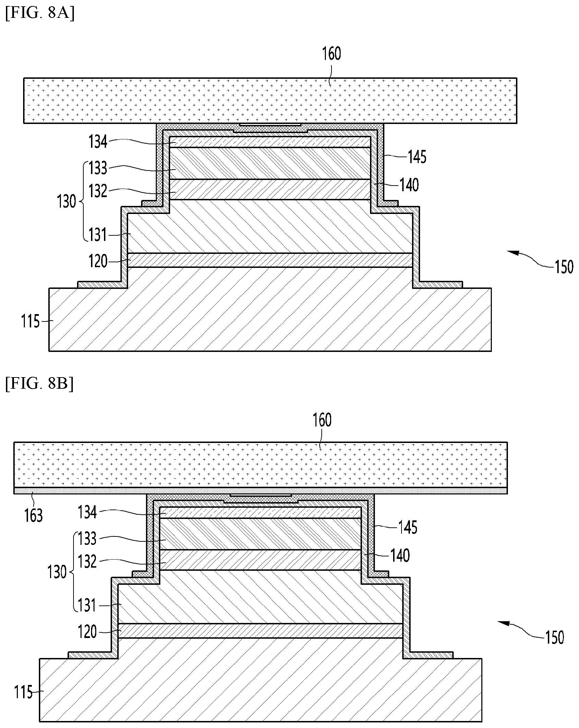

FIG. 8A is a conceptual view showing bonding of a semiconductor light-emitting device 150 and a transfer substrate 160 according to a first embodiment. Referring to FIG. 8A, the semiconductor light-emitting device formed in FIG. 7 may be bonded to the transfer substrate 160. In the first embodiment, after the sacrificial layer 145 is brought into direct contact with the transfer substrate 160, the sacrificial layer 145 and the transfer substrate 160 may be bonded under high temperature and high pressure conditions. The transfer substrate 160 may include sapphire Al2O3, but is not limited thereto.

At this time, an organic material may not be present between the passivation layer 140 of the semiconductor light-emitting device and the transfer substrate 160. Only the sacrificial layer 145 may be present between the semiconductor light-emitting device 150 and the transfer substrate 160.

Meanwhile, when the semiconductor light-emitting device is bonded to the transfer substrate without a separate bonding material (organic material), there is a problem that the semiconductor light-emitting device is damaged. For example, the first electrode 134 may be subjected to pressure and damaged during the bonding process. Accordingly, a lighting problem of the semiconductor light-emitting device may occur. In addition, there is a problem that air bubbles are trapped in a bonding region between the transfer substrate and the semiconductor light-emitting device so that the semiconductor light-emitting device is not bonded.

Meanwhile, in an embodiment, a temperature of the bonding process may be 100°C to 1000°C. In addition, in the bonding process, a pressure may be 500 N to 100 kN. In the embodiment, the sacrificial layer 145 and the transfer substrate 160 may be bonded within a temperature and pressure range of the bonding process. In addition, the temperature of the bonding process may be equal to or lower than a melting point of a material constituting the sacrificial layer. The sacrificial layer 145 may be bonded in a solid state rather than being bonded in a liquid state.

Accordingly, the embodiment can bond the semiconductor light-emitting device to the transfer substrate without a bonding material composed of an organic material. Accordingly, the embodiment can simplify the transfer process since the bonding process is possible without a patterning process of an organic material. In addition, the embodiment can prevent a problem in which an organic material acts as a foreign substance during fluid dispersion. In addition, the embodiment can improve alignment accuracy in a bonding region and improve a transfer rate even when the semiconductor light-emitting device is miniaturized.

In addition, FIG. 8B is a view showing bonding of a semiconductor light-emitting device and a transfer substrate according to a second embodiment. Referring to FIG. 8B, the transfer substrate 160 may further include a first metal layer 163. Accordingly, the sacrificial layer 145 of the semiconductor light-emitting device may be in direct contact with the first metal layer 163. The first metal layer 163 may include the same metal as the sacrificial layer 145, but is not limited thereto. The first metal layer 163 may include at least of Al, Cu, Ag, Au, Ni, Pt, W, Ti, Mo, Fe, Co, Sn, Zn, Pb, Mg, carbon steel, Inconel, or stainless steel, and may be formed of a combination of the same kind, different kinds, or three kinds thereof.

Under high temperature and high pressure conditions, a metal bond may occur between the first metal layer 163 and the sacrificial layer 145 due to diffusion in a solid state. Meanwhile, a process temperature may be equal to or lower than a melting point of metals of the first metal layer 163 and the sacrificial layer 145. Accordingly, the first metal layer 163 and the sacrificial layer 145 may be directly bonded without a separate bonding material.

Accordingly, the second embodiment can bond the semiconductor light-emitting device to the transfer substrate without using an organic material through metal bonding of the sacrificial layer 145 and the first metal layer 163. Accordingly, the second embodiment can prevent an organic material from acting as a foreign substance that interferes with transfer and can prevent contamination of the semiconductor light-emitting device.

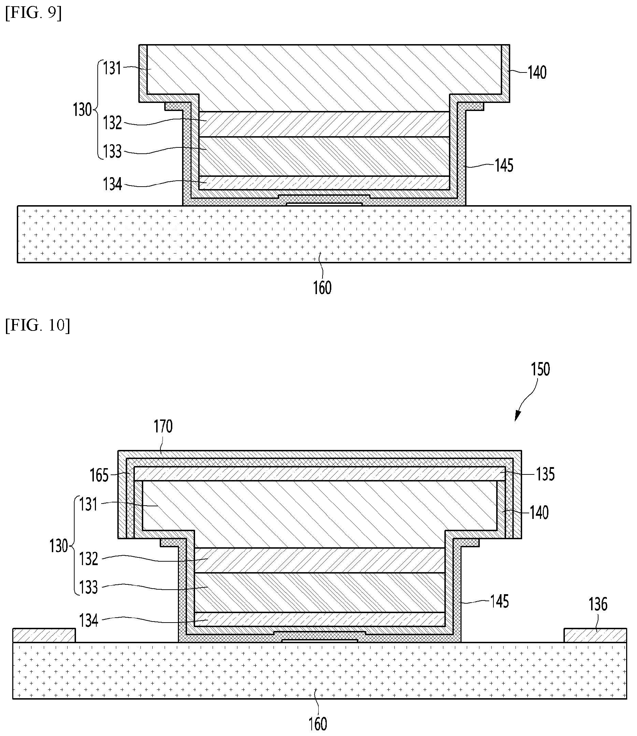

Referring to FIG. 9, after inverting the semiconductor light-emitting device bonded to the transfer substrate 160, a growth substrate may be removed. For removal of the growth substrate, LLO (Laser-lift off) or CLO (Chemical-lift off) may be used depending on an epi material. In addition, a portion of the passivation layer 140 and a buffer layer located on a rear surface of the semiconductor light-emitting device may be removed. Accordingly, a rear surface of the first conductivity type semiconductor layer 131 may be exposed.

Referring to FIG. 10, a second electrode 135 may be disposed on the first conductivity type semiconductor layer 131. Meanwhile, the second electrode 135 may include an ohmic contact layer. In addition, the second electrode 135 may include a magnetic layer.

Meanwhile, in a process of forming the second electrode 135, a second-first electrode 136 may also be formed in a region where the semiconductor light-emitting device is not bonded on the transfer substrate 160. The second-first electrode 136 is the same electrode as the second electrode 135. The second-first electrode 136 may be disposed to be spaced apart with the semiconductor light-emitting device interposed therebetween. The second-first electrode 136 may remain even if the semiconductor light-emitting device is separated from the transfer substrate 160.

In addition, a side electrode 165 may be disposed on the second electrode 135. In addition, the side electrode 165 may be disposed to cover the second electrode 135. The side electrode 165 may include a region in contact with the second electrode 135 and a region in contact with the passivation layer 140. The side electrode 165 may overlap the first conductivity type semiconductor layer 131 in a horizontal direction.

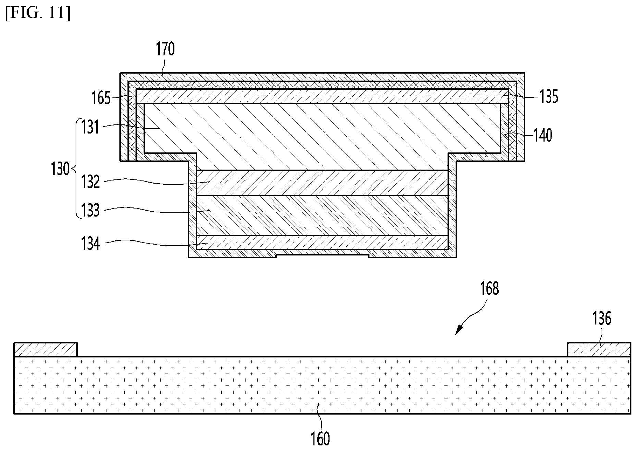

Referring to FIG. 11, the semiconductor light-emitting device 150 may be separated from the transfer substrate 160 by removing the sacrificial layer 145. The separated semiconductor light-emitting device 150 may be dispersed in a fluid and assembled on an assembly substrate. Meanwhile, the transfer substrate 160 may include a bonding region 168 in which the semiconductor light-emitting device 150 was bonded. In the bonding region 168, a surface of the transfer substrate 160 may be exposed as it is. Specifically, in the bonding region 168, a bonding material, for example, an organic material, may not be present. In addition, the transfer substrate 160 may include the second-first electrode 136 outside the bonding region 168. A distance between the spaced second-first electrodes 136 may correspond to a diameter of the semiconductor light-emitting device.

In addition, when the semiconductor light-emitting device is bonded and separated in a state in which the first metal layer 163 is formed on the transfer substrate 160 in FIG. 8B, the first metal layer 163 may remain on the transfer substrate 160. In this case, the first metal layer 163 is disposed on the transfer substrate 160, and the second-first electrode 136 may be disposed on the first metal layer 163. In addition, in the bonding region of the transfer substrate 160, a surface of the first metal layer 163 may be exposed as it is.

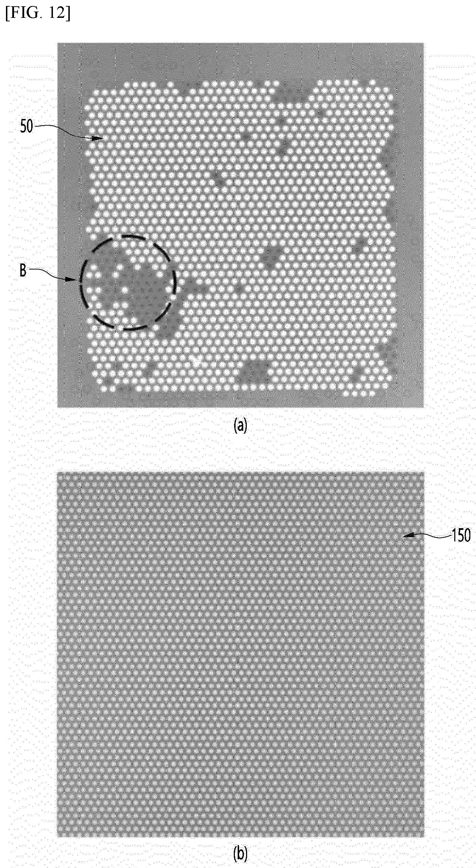

FIG. 12A is a view showing a transfer substrate of a semiconductor light-emitting device internally developed technology. Referring to FIG. 12A, in the transfer substrate of the semiconductor light-emitting device, the semiconductor light-emitting device 50 may be bonded. Meanwhile, an organic material is used in a bonding process, which reduces stability of the bonding process and may act as a foreign substance to interfere with bonding of the semiconductor light-emitting device. Accordingly, as in region B, there is a problem that a transfer yield is greatly reduced because the semiconductor light-emitting device is not bonded.

Meanwhile, FIG. 12B is a view showing a transfer substrate of a semiconductor light-emitting device to which the embodiment is applied. Referring to FIG. 12B, in the embodiment, the semiconductor light-emitting device 150 may be bonded on the transfer substrate of the semiconductor light-emitting device without an organic material. Accordingly, the embodiment can improve a transfer yield by removing a foreign substance factor and can improve stability of a bonding process. In particular, the embodiment can significantly improve a bonding yield compared to FIG. 12A which has been internally developed technology.

The transfer method of the semiconductor light-emitting device for a display pixel according to the embodiment has a technical effect that a transfer process of the semiconductor light-emitting device can be simplified.

For example, the embodiment can simplify the transfer process by performing the bonding process without organic material patterning.

In addition, the embodiment has a technical effect that contamination of the semiconductor light-emitting device can be prevented in the transfer process.

For example, the embodiment can prevent contamination of the semiconductor light-emitting device because the bonding process is performed without forming an organic material acting as a foreign substance in a fluid.

In addition, the embodiment has a technical effect that misalignment of a miniaturized chip can be prevented.

For example, the embodiment can prevent a problem in which a chip is misaligned due to fluidity of an organic material during bonding.

In addition, the embodiment has a technical effect that a transfer rate of the semiconductor light-emitting device can be improved.

For example, the embodiment can prevent a foreign substance from penetrating into an assembly hole and interfering with transfer of the semiconductor light-emitting device.

Although the embodiments of the present invention have been described above with reference thereto, those skilled in the art will readily understand that the present invention may be variously modified and changed without departing from the spirit and scope of the present invention as set forth in the claims below.

### Industrial Applicability

The embodiment can be applied to a display device, but is not limited thereto. For example, the embodiment can be applied to a micro-LED display using an LED, which is an inorganic light-emitting device, as a light-emitting pixel, but is not limited thereto.

## Claims

1. A method for transferring a semiconductor light-emitting device for a display pixel, comprising:
providing a semiconductor light-emitting device comprising a light-emitting structure and a passivation layer disposed on the light-emitting structure, the light-emitting structure including a first conductivity type semiconductor layer, an active layer disposed on the first conductivity type semiconductor layer, and a second conductivity type semiconductor layer disposed on the active layer;
forming a sacrificial layer on the semiconductor light-emitting device; and
bonding the semiconductor light-emitting device to a transfer substrate with the sacrificial layer interposed therebetween, and
wherein the sacrificial layer is disposed between the semiconductor light-emitting device and the transfer substrate.

2. The method for transferring the semiconductor light-emitting device for the display pixel according to claim 1, wherein an organic material is not disposed between the semiconductor light-emitting device and the transfer substrate.

3. The method for transferring the semiconductor light-emitting device for the display pixel according to claim 1,
wherein the sacrificial layer comprises at least one of Al, Cu, Ag, Au, Ni, Pt, W, Ti, Mo, Fe, Co, Sn, Zn, Pb, Mg, carbon steel, Inconel, or stainless steel.

4. The method for transferring the semiconductor light-emitting device for the display pixel according to claim 1, wherein the transfer substrate further comprises a first metal layer.

5. The method for transferring the semiconductor light-emitting device for the display pixel according to claim 4, wherein the first metal layer comprises the same metal as the sacrificial layer.

6. The method for transferring the semiconductor light-emitting device for the display pixel according to claim 1, further comprising forming a second electrode on a rear surface of the first conductivity type semiconductor layer.

7. The method for transferring the semiconductor light-emitting device for the display pixel according to claim 6, further comprising forming a side electrode on a rear surface of the second electrode.

8. The method for transferring the semiconductor light-emitting device for the display pixel according to claim 7,
wherein the transfer substrate comprises a bonding region in which the semiconductor light-emitting device is bonded, and a second-first electrode disposed outside the bonding region of the transfer substrate.

9. The method for transferring the semiconductor light-emitting device for the display pixel according to claim 1,
further comprising removing the sacrificial layer to separate the semiconductor light-emitting device from the transfer substrate,
wherein in the bonding region of the transfer substrate, a surface of the transfer substrate is exposed.

10. The method for transferring the semiconductor light-emitting device for the display pixel according to claim 1,
wherein the bonding the semiconductor light-emitting device to the transfer substrate is performed within a range of 100 to 1000, and a pressure is within a range of 500 N to 100 kN.
